# EUROPEAN PATENT SPECIFICATION

(11) **EP 2 984 683 B1**
(45) Date of publication and mention of the grant of the patent: **15.02.2017**
(21) Application number: 14738373.1
(22) Date of filing: 03.04.2014
(51) Int. Cl.: H01L 31/052

(54) **SOLAR CONCENTRATOR FOR PHOTOVOLTAIC SYSTEMS**
SONNENKONZENTRATOR FÜR FOTOVOLTAIKANLAGEN
CONCENTRATEUR SOLAIRE POUR SYSTÈMES PHOTOVOLTAÏQUES

(30) Priority: 10.04.2013 IT MI20130567
(43) Date of publication of application: 17.02.2016
(73) Proprietor: Ricerca Sul Sistema Energetico - RSE S.p.A., 20134 Milano (IT)
(72) Inventor: TRESPIDI, Franco, I-20122 Piacenza (IT)
(74) Representative: Ferraiolo, Ruggero
(86) International application number: PCT/EP2014/000895
(87) International publication number: WO 2014/166609

(56) References cited:
- US-A- 4 114 592
- US-A1- 2009 114 213
- US-A1- 2011 067 688
- US-A1- 2012 138 047

## Description

The invention relates to a reflection solar concentrator for photovoltaic optical systems that work under a high concentration factor, in particular, a concentrator made by a primary optical system that can be achieved with an off-axis paraboloid or another equivalent surface for the purpose of reflecting the solar rays, such as a portion of a spherical or elliptical surface or other curved surfaces adapted to focus the radiation (surfaces that will be conventionally called "paraboloid/s" in the following) and by a secondary optical element that acts mainly as a homogenizer and also as a concentrator of the solar rays on a collection cell.

### Prior art

The techniques of reflection solar concentration that work under high concentration factor use for most part systems symmetrical with respect to a central axis (Cassegrain type). The advantage of these systems is to be very compact equipments, while the disadvantage is to have a central obscuration caused by the secondary optics or by the collection cell, which penalizes the collection efficiency.

Other systems using off-axis parabolic concentrators mount the cell in the upper position or at their half height. These arrangments do not help the heat dissipation which, in that cases, may be performed on the upper side, side illuminated by the sun, or on the side wall that, in a complete system, is normally not directly exposed to the outside, thus reducing the efficiency of the heat The documents US2009/114213A and US 4 114 592A describe solar concentrators.

For a system that uses the same primary optical system comprising an off-axis paraboloid the use of any conventional homogenizer of truncated pyramid or truncated cone shape does not allow to get the maximum performances in terms of angular acceptance. The angular acceptance means, in this technical field, the maximum acceptable misalignment angle between the source, the sun and the collection and concentration optical system. As maximum acceptable angular misalignment is usually defined the one within which the efficiency of the radiation collection is greater than a fraction of the maximum value, fraction which, for example, may be 90%.

In particular, documents U.S. 7,607,429 B2, U.S. 5,180,441 and U.S. 2010/0275972 A1 are known in this field. The first document shows a manifold which concentrates the radiation in one direction and uses a plurality of mirrors as optical primary elements that send the radiations to an optical secondary element also of the reflection type, but of symmetric type. The second document discloses a solar concentrator panel which involves a series of cylindrical parabolic off-axis mirrors with an optical arrangement of solar cells of relatively reduced focal length and arranged to convert sunlight into electricity, the rear surfaces of the mirrors being used as support for solar cells and as heat dissipating surfaces for the cells mounted on them; the reflected sunlight may be directed onto the solar cells mounted on the back of the adjacent mirrors. The third document discloses an off-axis concentrator which includes a chamber defined by a receiver wall, a reflective wall and at least two end walls, all together defining a three-dimensional object provided with an inlet in which a vertical axis of the chamber is generally perpendicular to the inlet and includes a receiver mounted on the wall of the receiving chamber, the receiver carrying at least one photovoltaic cell, a vertical axis of the receiver being arranged according to an angle different from zero with respect to the vertical axis of the chamber and other arrangements being suitable to align the optical element with the receiver.

### Drawbacks in the prior art.

In general, the use of a conventional homogenizer, which has a top opening parallel to the plane of the cell, does not allow to better collect the rays from an off-axis paraboloid in the presence of the misalignment of the collection system of the radiation relative to the sun. In particular, the documents U.S. 5,180,441 and U.S. 2010/0275972 A1 relate to solutions in which off-axis paraboloids are used for the focusing of the beam, but without a homogenizer. Besides, the cell is placed in the upper level of the module (i.e. of the set of concentrators) and not in the lower level as proposed in this invention that, instead, favors the thermal dissipation of the photovoltaic cell. The document U.S. 7,607,429 B2 discloses a concentrator of cylindrical type which nevertheless has a homogenizer of symmetrical shape, with the top section parallel to the section of the plane of the cell.

### Technical problem solved by the invention

The problem that the invention solves by means of the primary and secondary optical systems is to concentrate the solar radiation on the cell in a conveniently high and uniform manner and to ensure at the same time a high angular acceptance of the overalloptical system.

### Disclosure of the invention

The invented solar concentrator is conventionally constituted by a primary optical system realized with an off-axis paraboloid and a secondary optical element that acts as a homogenizer that, in a new way, presents its own inlet opening for the radiation (in the following "top opening") in a position not perpendicular to its symmetry central axis, a position which in the following description will be conventionally called "oblique" and which is adapted to collect that part of the radiation that would be lost if it were parallel to the plane of the homogenizer exit opening ("bottom opening") which in turn is parallel to the plane of the underlying photovoltaaic cell and that allows to track the position of "best focus" created by the aberrations of the off-axis paraboloid, thus collecting a greater number of rays, thus improving the characteristics of angular acceptance of the system in the presence of misalignments, without changing the maximum efficiency obtainable by the optical system.

The reason for the oblique cross section is related to the aberrations produced by the off-axis paraboloid, or anyway by a focusing optics of the radiation which works in a non-symmetrical way. The asymmetric behavior of the off-axis paraboloid as a function of the solar misalignment in the median plane means that the position of the "best focus" (the point of best focus of the beams coming from the off-axis paraboloid) moves along a line not necessarily straight and not parallel to the plane of the cell positioned at the bottom of the homogenizer.

As it will be evident from the examples of embodiment, the system maximizes the collection of the radiation under high angles of solar misalignment without having to increase the slope of the pyramid or cone, i.e. the angle at the apex of the pyramid or cone from which the homogenizer is obtained, increase of slope that would jeopardize the efficiency of the concentrator.

Note that an extension of the entire homogenizer, to maintain the conventional shape, would result in the block of some rays in the presence of certain misaligments, as will be seen in some of the attached figures.

This is an evidence that in this optical configuration the optimal shape of the homogenizer can not be the conventional one, but the shape must have a top opening in an oblique position with respect to its central axis of symmetry.

The aberrations generated by the off-axis paraboloid make the best focus, in a first approximation, move along a straight oblique line.

The angle of inclination of said oblique position will be determined in function of the geometrical characteristics of the off-axis paraboloid and of the inclination of the homogenizer with respect to the primary mirror.

In principle, the profile of the top opening could also be curved in the case in which the best focus produced by the aberrations moves along a not straight line.

The homogenizer with oblique top opening can be of a truncated pyramid shape, truncated-conical shape or of another mixed shape that will be described in one of the examples of embodiment.

It is noted that, to optimize the collection of the radiation, the symmetry central axis of the homogenizer is tilted a few degrees with respect to the optical axis coming from the primary mirror, this allowing to optimize the coupling between the primary optical system and the secondary oblique optical element

The effects of the invented homogenizer are preliminarily shown in the graphs of Figures A, B, C, where the sizes are compared of the areas defined by the iso-efficiency curves of the optical system, depending on the orthogonal angles of the sun misalignment. The more the area defined by the iso-efficiency curves is wide, the greater is the angular acceptance of the system. The comparison between said sizes is done while maintaining the shape of the off-axis paraboloid and simulating both a conventional homogenizer of truncated pyramid shape and a homogenizer of truncated pyramid shape with a top oblique opening.

In the example of Figure A, the misalignment angle in the plane considered (the one who benefits from the use of the present new homogenizer) is the angle Phi. The figure shows the iso-efficiency curve at 90% of the maximum value of efficiency as a function of the angles of the orthogonal misalignment, the curve being obtained by a conventional homogenizer. of truncated pyramid shape.

Fig B shows the iso-efficiency curve at 90% of the maximum value of efficiency as a function of the angles of orthogonal misalignment, the curve being obtained with a conventional truncated pyramidal homogenizer modified to have a top oblique opening.

Figure C shows the comparison between the iso-efficiency curves at 90% of the maximum value of efficiency obtained with the two homogenizers: the dashed curve refers to a conventional homogenizer, the entire curve refers to a homogenizer with top oblique opening. As it can be seen from the comparison between said two curves, in the case of a concentrator that makes use of a homogenizer made with top oblique opening with respect to the central axis of symmetry, there is an increase of the average angular acceptance (equivalent to the area inscribed in the curve).

The iso-efficiency curves are calculated at 90% of the maximum value, this value being typically used to define the angular acceptance. The result obtained is, however, of general type and also applies to iso-efficiency curves calculated with different percentages.

The same observation could however be extended to the orthogonal angle of misalignment. In fact, one may consider a paraboloid that works off-axis also with respect to the second misalignment axis; this would cause the homogenizer shift to an angle of the optical system. In the above case, also in the other misalignment plane, the one identified by the angle theta, one would benefit from an inclination of the top oblique opening in the homogenizer.

An alternative to the above shown homogenizer is a homogenizer provided with a top oblique circular or elliptical opening turning into a square or rectangular bottom opening.

To clarify the meaning of "oblique" referred to the homogenizer top opening it is noted that the obliquity of said opening with respect to the main axis of symmetry of the homogenizer is the obliquity with respect to one or the other of the two misalignment directions with respect to a misalignment direction intermediate to the two mentioned above, also with respect to the plane of the cell.

### Advantages of the invention

The geometry of the system is such as to maintain the position of the cell in the lower part of the optical system and makes it possible to use less efficient tracking systems for tracking the sun and to help the heath dissipation that occurs effectively by taking advantage, as a dissipative element, of the homogenizer lower wall which is exposed to the outside and is located advantageously in the shadow. Furthermore, in case of misalignment of the receiving system, the collection efficiency, homogenization and concentration of the light radiation are improved thanks to the greater angular acceptance as offered by the homogenizer. Finally, the use of an off-axis paraboloid as primary optics, or similar shape suitable to focus the solar radiation without obstruction of the incoming beam, avoids to obscure part of the collection area and maximizes the radiation captured.

### Detailed description of the invention

The invention will now be described in more detail with examples of embodiment and the help of diagrammatic drawings, in which
- Figs. 1a, 2 - 5 and 10, 11 are plan views and the
- Figs. 1b, 6a - 9 are three-dimensional views.

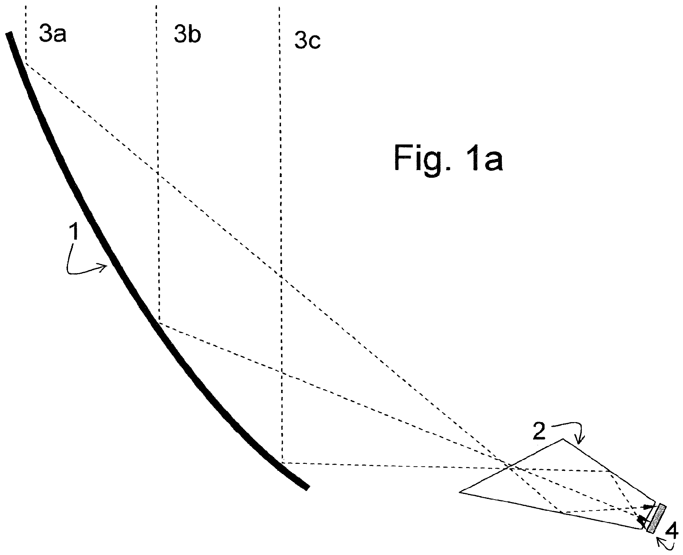

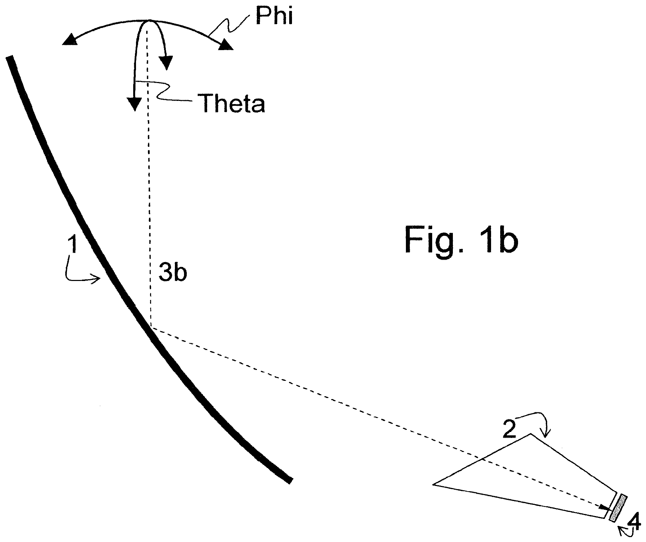

Fig. 1 shows a concentration system composed of an off-axis paraboloid, or primary mirror 1, and by a homogenizer 2. The primary mirror is able to send the solar radiation within the homogenizer that has a shape suitable to collect at best the solar radiation 3a, 3b, 3c coming from the primary mirror 1 and send it to the photovoltaic cell 4 that converts the electromagnetic radiation into electric current.
Figure 1b shows the two directions of misalignment Phi and Theta considered to simulate the misalignment of the solar rays with respect to the collection optical system. The misalignment Phi lies in the plane of the drawing and the misalignment Theta lies in the plane orthogonal to the drawing and passing through the beam 3b considered in the condition of zero misalignment.

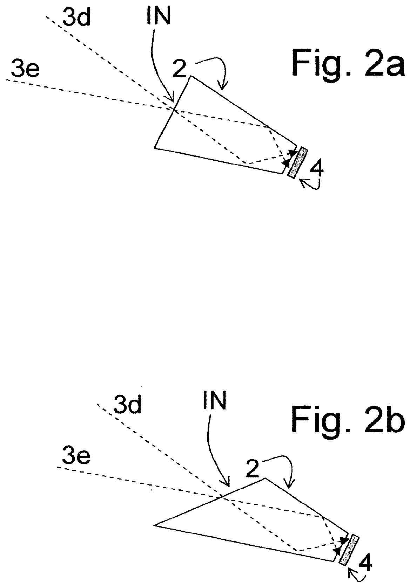

Fig. 2a shows a homogenizer 2 of conventional shape in which the rays 3d and 3e are reflected from the reflective surface of the homogenizer until they arrive at the photovoltaic cell 4 at the bottom of the homogenizer.The top opening IN of the homogenizer 2 is parallel to the bottom opening and is not optimized to gather the incoming radiation at best.
Fig. 2b shows a homogenizer that, shaped as truncated cone with a top opening oblique with respect to the central axis of symmetry, is suitable to collect the maximum amount of radiation coming from the primary mirror (of which two rays 3d and 3e are shown) and distribute it evenly on the photovoltaic cell 4. The homogenizer top opening IN, oblique with respect to the central axis of symmetry, it is also oblique with respect to one or the other of the two directions of misalignment or with respect to a direction of misalignment intermediate to the above two.

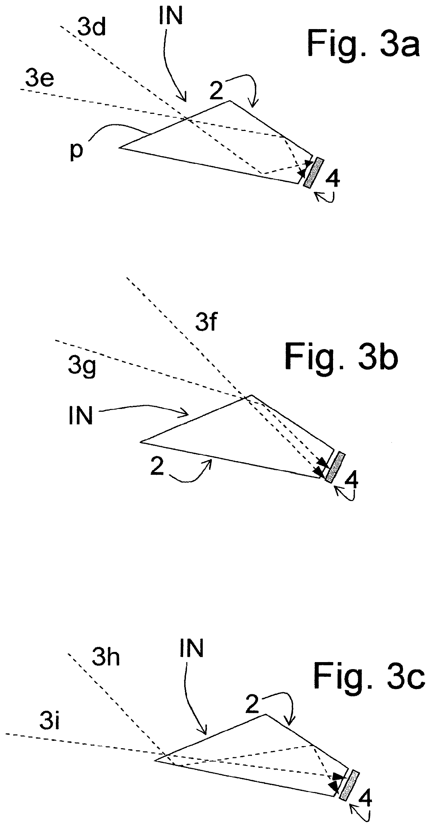

Fig. 3a shows a homogenizer 2 shaped according to the invention in the case where the sun is aligned with the optical system of collection.The rays 3d and 3e coming from the primary mirror are focused near the center of the homogenizer 2 top opening IN, top opening which is a surface bounded by the profile p.
Fig. 3b shows a homogenizer 2 in the case where the sun has a positive misalignment in a direction with respect to the primary mirror, and then with respect to the entire collection optical system.The rays 3f and 3g, coming from the primary mirror, are focused in the vicinity of an edge of the top opening IN of the homogenizer 2 and sent to the cell 4. As well known, the mixing (homogenization) of the rays on the photovoltaic cell 4 normally occurs as a result of a series of bounces within the homogenizer 2, which for simplicity of representation are not shown in the figure.
Fig. 3c shows a homogenizer 2 in the case where the sun has a negative misalignment in a direction with respect to the collection optical system.The rays 3f and 3g, coming from the primary mirror are focused in the vicinity of an edge of the top opening IN of the homogenizer 2 and sent to the photovoltaic cell 4. As known, the mixing (homogenization) of the rays on the cell 4 normally occurs as a result of a series of bounces within the homogenizer 2 not shown in the drawing. Note that in Figures 3a, 3b and 3c the best focus, i.e. the point where the rays meet at the entrance of the homogenizer, is not located at the same distance from the cell, but varies due to the aberrations produced by the primary optics as a function of the solar misalignment. The effect of the solar misalignment on the focusing the beam entering the homogenizer is made clear in the following figure.

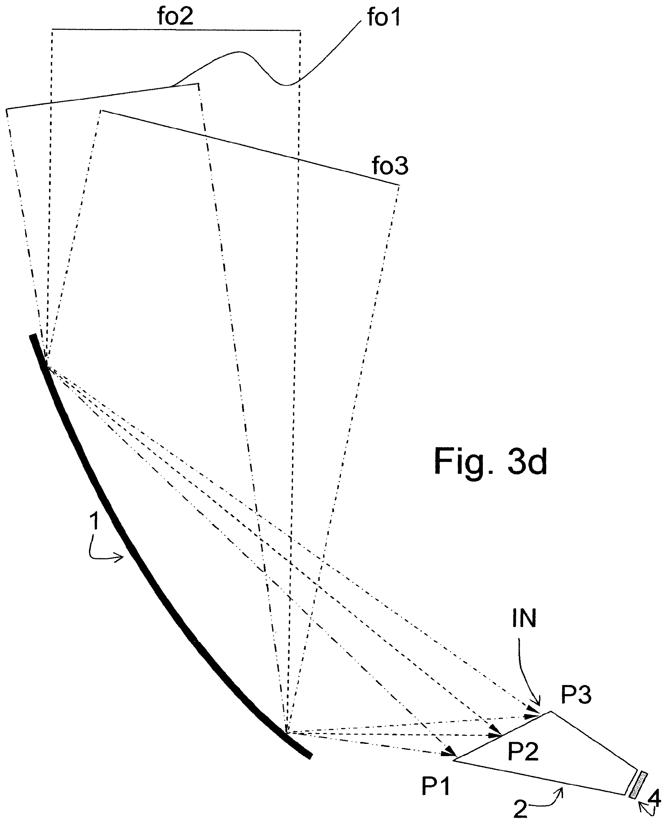

Fig. 3d shows in fact how a misalignment of the beam of sunlight with respect to the collection optical system makes the beam be focused on a substantially flat surface, not parallel to the plane of the cell because of the aberrations present in the optical system. The maximization of the collection of solar rays, then the maximization of the angular acceptance of the optical system, is obtained when the top opening IN of the homogenizer 2 follows the shape of said surface not parallel to the plane of the photovoltaic cell 4. FO1, FO2, FO3 indicate the wavefront of the incident radiation that will be focused respectively in P1, P2, P3.

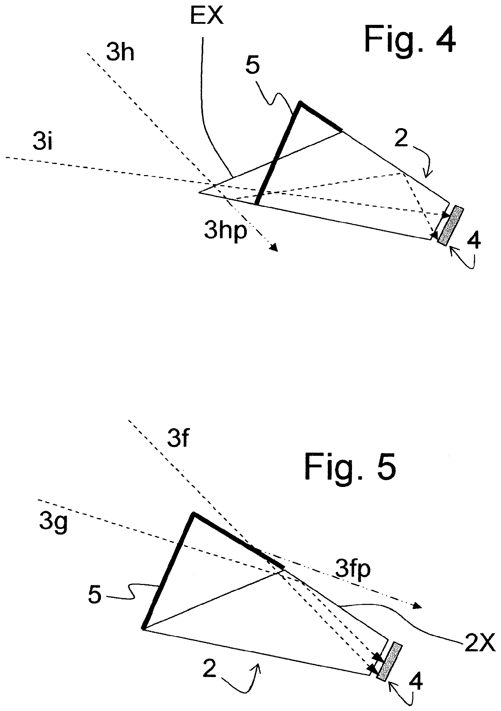

Fig. 4 shows the effect of the extension EX of a side of the homogenizer 2. The system maximizes the collection of radiation under high angles of solar misalignment without having to increase the angle at the vertex of the cone of origin, an operation that would jeopardize the efficiency of the concentrator. The radius 3h is collected by the homogenizer and sent to the photovoltaic cell and 4, while, if the shape of the homogenizer had been the conventional one, shown with the profile 5, the radius 3h would be lost as shown with the extension 3hp.
Fig. 5 shows the effect of shortening the side 2X in the homogenizer 2. The system maximizes the radiation collection under high angles of solar misalignment without having to increase the angle at the vertex of the source cone, an operation that would jeopardize the efficiency of the concentrator.The radius 3f is collected by the homogenizer and sent to the photovoltaic cell 4, while, if the shape of the homogenizer had been the conventional one as shown with the profile 5, the radius 3f would be absorbed by the outer wall of the homogenizer or reflected following the path indicated by the radius 3fp.

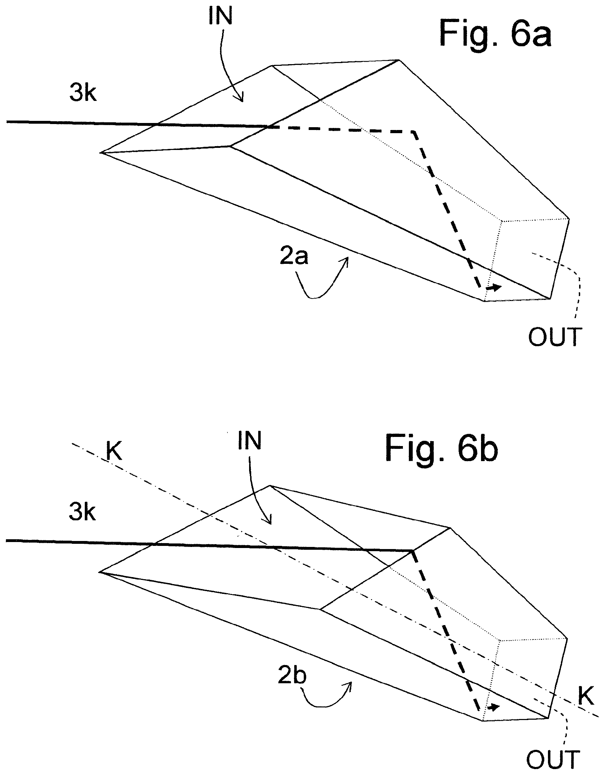

Fig. 6a is a three dimensional view of a truncated pyramid shaped homogenizer 2a with top opening IN, parallelogram-shaped, oblique with respect to the central axis of symmetry, in which opening the solar radiation enters, exemplified with the radius 3k, for being reflected until getting the bottom opening OUT.
Fig.6b is a three dimensional view of a truncated pyramid shaped homogenizer 2b with top opening IN oblique with respect to both the directions of misalignment.The radiation, exemplified by the radius 3k, enters through the top oblique opening and is reflected until getting the bottom opening OUT. K- K shows the central axis of the homogenizer 2b.

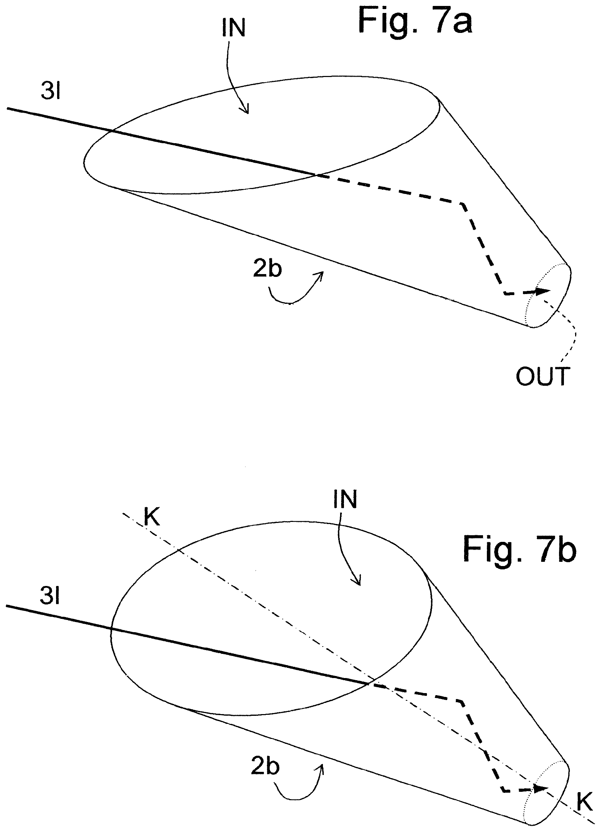

Fig. 7a is a three dimensional view of a truncated cone homogenizer 2b with the top opening IN oblique with respect to the central axis of symmetry in which the radiation enters, exemplified with the radius 31, which is reflected until getting the bottom opening OUT.
Fig.7b is a three dimensional view of a truncated cone homogenizer 2b with top opening IN oblique with respect to both the directions of misalignment. The radiation, exemplified by the radius 31, enters through the top opening and is reflected until getting the bottom opening OUT. K - K shows the central axis of symmetry of the homogenizer 2b.

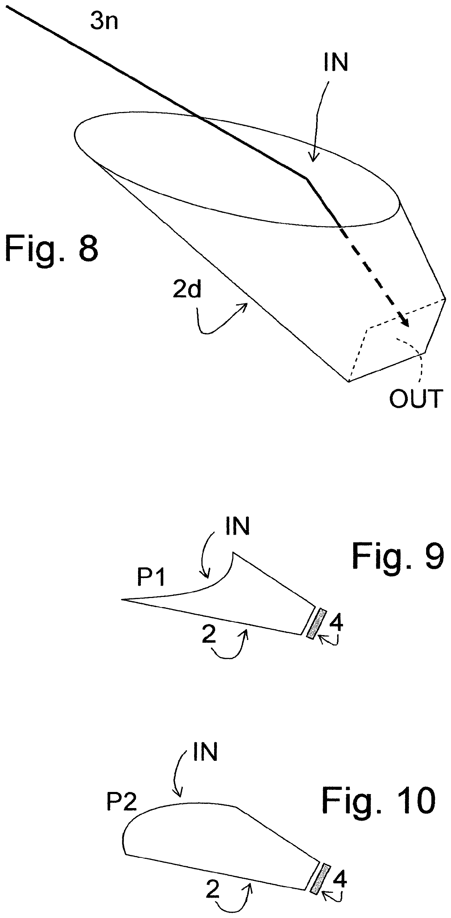

Fig. 8 is a three dimensional view of a homogenizer (defined in this example - mixed homogenizer - as it has the top section round or elliptical and the lower section square or rectangular) having the top opening IN elliptical and oblique with respect to the central axis of symmetry in which the solar radiation enters, exemplified with the radius 3n which is reflected until getting the bottom section OUT of square or rectangular shape.
Fig. 9 shows the concave shape P1 of the top opening IN in a homogenizer 2. This shape is different from the straight one so as to maximize the collection of the solar radiation coming from the primary mirror. For example, this shape may follow the position of the best focus produced by the primary mirror.
Fig. 10 shows the convex shape P2 of the top opening IN in a homogenizer 2. This shape is different from the straight one so as to maximize the collection of the radiation coming from the primary mirror. This shape too can follow the position of the best focus produced by the primary mirror.

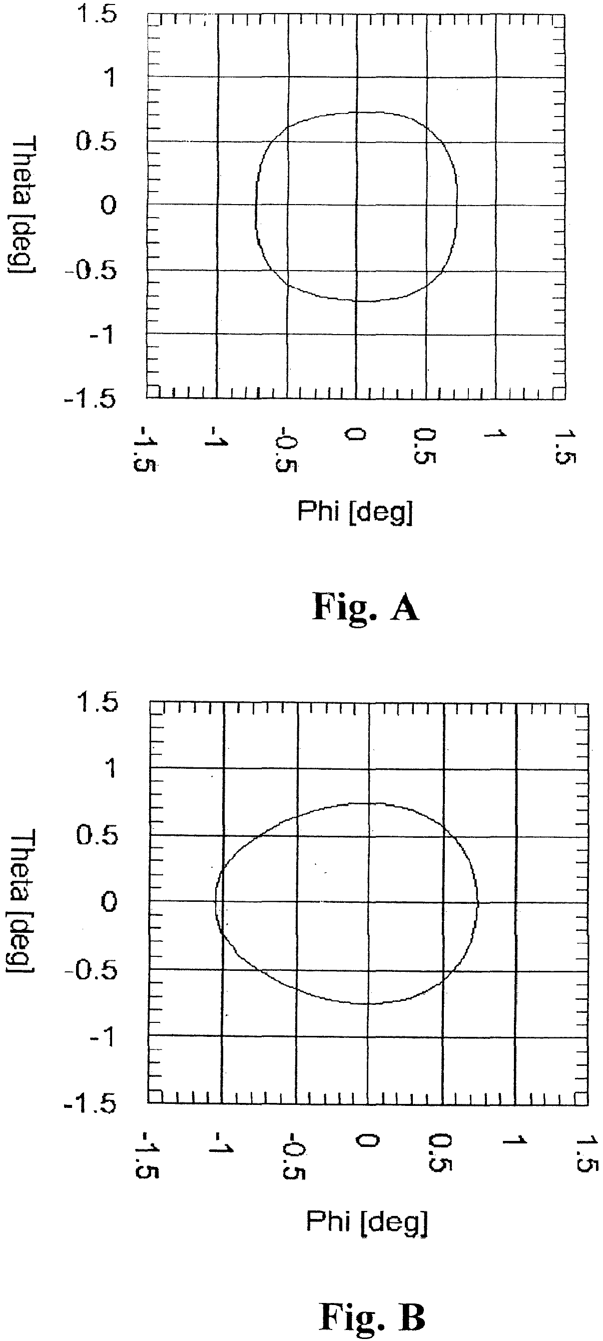

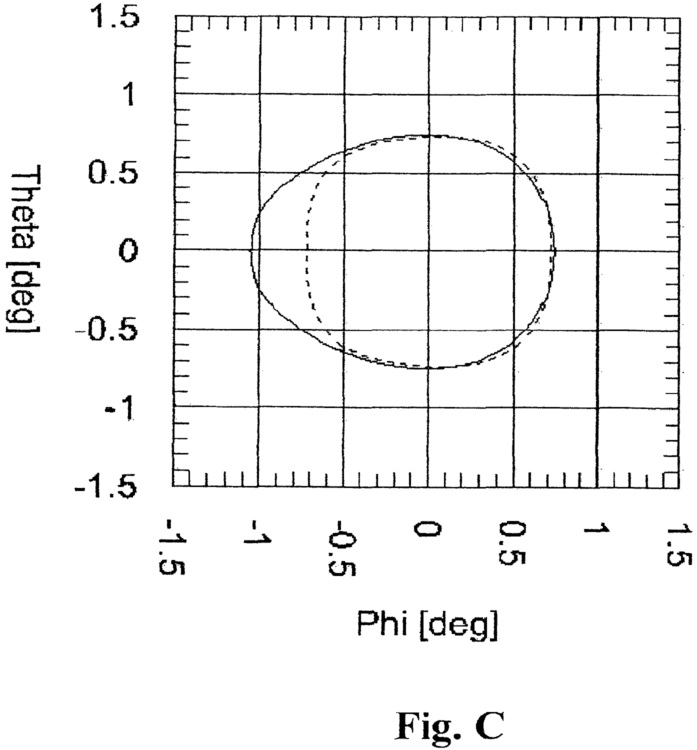

## Claims

1. Solar concentrator (1, 2) for photovoltaic systems comprising a primary optical system (1) and a secondary optical element (2), the primary optical system being provided with an off-axis paraboloid or other means to focus the solar radiation on the secondary optical element working as a homogenizer, **characterized in that** the homogenizer (2) has the shape of a truncated pyramid or truncated cone and is provided with a top opening (IN) not perpendicular to the homogenizer central axis of symmetry (K - K) to adapt to the abberations of the primary optical system, significantly to obviate sun pointing errors and maximize the capture of the rays coming from the primary optical system (1).

2. Solar concentrator (1, 2) for photovoltaic systems comprising a primary optical system (1) and a secondary optical element (2), the primary optical system being provided with a off-axis paraboloid (1), or other means to focus the solar radiation on the secondary optical element working as a homogenizer, **characterized in that** the upper opening (IN) of the homogenizer (2) is defined by a circle or an ellipse not perpendicular to the central axis of symmetry (K - K) of the homogenizer and the bottom opening (OUT) is defined by a square or a rectangle parallel to the plane of the photovoltaic cell (4) of the system and having an area next to the area of the cell.

3. Solar concentrator according to claim 1 **characterized in that** the paraboloid (1) works off-axis with respect to both the solar misalignment axes (Phi, Theta) and the homogenizer (2) of truncated pyramid or truncated cone shape is provided with an top opening (IN) not perpendicular to the central axis of symmetry (K - K) with respect to one or both the orthogonal directions of solar misalignment (Phi, Theta).

4. Solar concentrator according to claim 1 **characterized in that** the top opening (IN) of the homogenizer (2) is oblique with respect to the central axis of symmetry (K - K) of the homogenizer and is concave, convex or concave-convex to fit to the aberrations of the optical system primary (1), so as to maximize the collection of solar radiation.

## Patentansprüche

1. Solarkonzentrator (1, 2) für Fotovoltaiksysteme mit einem primären optischen System (1) und einem sekundären optischen Element (2), wobei das primäre optische System mit einem achsenversetzten Paraboloiden oder anderen Mitteln zum Fokussieren der Sonnenstrahlung auf dem sekundären optischen Element versehen ist, das als ein Homogenisierer arbeitet, **dadurch gekennzeichnet, dass** der Homogenisierer (2) die Form eines Pyramidenstumpfes oder eines Kegelstumpfes aufweist und mit einer oberen Öffnung (IN) versehen ist, die nicht rechtwinklig zu der Symmetrie-Mittenlachse (K-K) des Homogenisierers ist, um an die Abberationen des primären optischen Systems anzupassen, im Wesentlichen um Sonnen-Zeigefehler zu verhindern und den Einfang der Strahlen, die von dem primären optischen System (1) stammen, zu maximieren.

2. Solarkonzentrator (1, 2) für Fotovoltaiksysteme mit einem primären optischen System (1) und einem sekundären optischen Element (2), wobei das primäre optische System mit einem achsenversetzten Paraboloiden oder anderen Mitteln zum Fokussieren der Sonnenstrahlung auf dem sekundären optischen Element versehen ist, das als ein Homogenisierer arbeitet, **dadurch gekennzeichnet, dass** die obere Öffnung (LIN) des Homogenisierers (2) durch einen Kreis oder eine Ellipse definiert ist, die nicht rechtwinklig zu.der Symmetrie-Mittelachse (K-K) · des Homogenisierers ist, und die untere Öffnung (OUT) durch ein Quadrat oder ein Rechteck definiert ist, das parallel zu der Ebene der Fotovoltaikzelle (4) des Systems ist und einen Bereich in der Nähe des Bereichs der Zelle aufweist.

3. Solarkonzentrator nach Anspruch 1, **dadurch gekennzeichnet, dass** der Paraboloid (1) hinsichtlich beider Sonnen-Fehlausrichtungsachsen (Phi, Theta) achsenversetzt arbeitet und der Homogenisierer (2) in Form des Pyramidenstumpfes oder des Kegelstumpfes mit einer oberen Öffnung (IN) versehen ist, die nicht rechtwinklig zu der Symmetrie-Mittelachse (K-K) mit Bezug auf eine oder beide orthogonale Richtungen der Sonnen-Fehlausrichtung (Phi, Theta) ist.

4. Solarkonzentrator nach Anspruch 1, **dadurch gekennzeichnet, dass** die obere Öffnung (IN) des Homogenisierers (2) mit Bezug auf die Symmetrie-Mittelachse (K-K) des Homogenisierers geneigt angeordnet ist und konkav, konvex oder konkav-konvex ist, um an die Abberationen des optischen Primärsystems (1) anzupassen, um die Sammlung von Sonnenstrahlung zu maximieren.

## Revendications

1. Concentrateur de rayonnement solaire (1, 2) destiné à des systèmes photovoltaïques comprenant un système optique primaire (1) et un élément optique secondaire (2), le système optique primaire étant équipé d'un paraboloïde désaxé ou d'autres moyens permettant de focaliser le rayonnement solaire sur l'élément optique secondaire, travaillant en tant qu'homogénéisateur,
**caractérisé en ce que**
l'homogénéisateur (2) a la forme d'une pyramide tronquée ou d'un cône tronqué et est équipé d'une ouverture supérieure (IN) non perpendiculaire à l'axe de symétrie médian (K-K) de l'homogénéisateur pour permettre une adaptation aux aberrations du système optique primaire, remédier de manière significative aux erreurs de pointage du soleil et rendre maximum la capture des rayons provenant du système optique primaire (1).

2. Concentrateur de rayonnement solaire (1, 2) destiné à des systèmes voltaïques comprenant un système optique primaire (1) et un élément optique secondaire (2), le système optique primaire étant équipé d'un paraboloïde désaxé (1) ou d'autres moyens permettant de focaliser le rayonnement solaire sur l'élément optique secondaire travaillant en tant qu'homogénéisateur,
**caractérisé en ce que**
l'ouverture supérieure (IN) de l'homogénéisateur (2) est définie par un cercle ou une ellipse non perpendiculaire à l'axe de symétrie médian (K-K) de l'homogénéisateur et l'ouverture inférieure (OUT) est définie par un carré ou un rectangle parallèle au plan de la cellule photovoltaïque (4) du système et ayant une surface située après la surface de la cellule.

3. Concentrateur de rayonnement solaire conforme à la revendication 1,
**caractérisé en ce que**
le paraboloïde (1) travaille avec un désaxage par rapport aux axes de désalignement du rayonnement solaire (Phi, Theta) et l'homogénéisateur (2) en forme de pyramide tronquée ou de cône tronqué est équipé d'une ouverture supérieure (IN) non perpendiculaire à l'axe de symétrie médian (K-K) par rapport à l'une ou aux deux directions perpendiculaires de désalignement du rayonnement solaire (Phi, Theta).

4. Concentrateur de rayonnement solaire conforme à la revendication 1,
**caractérisé en ce que**
l'ouverture supérieure (IN) de l'homogénéisateur (2) est oblique par rapport à l'axe de symétrie médian (K - K) de l'homogénéisateur et est concave, convexe ou concave-convexe pour s'adapter étroitement aux aberrations du système optique primaire (1) de façon à rendre maximum l'efficacité de collection du rayonnement solaire.
